# FASCICULE DE BREVET EUROPEEN

(11) **EP 3 671 836 B1**
(45) Date de publication et mention de la délivrance du brevet: **12.06.2024**
(21) Numéro de dépôt: 19213818.8
(22) Date de dépôt: 05.12.2019
(51) Int. Cl.: H01L 27/12, H01L 27/06, H01L 21/822, H01L 21/8234

(54) **CIRCUIT 3D DOTE D'UNE ISOLATION MESA POUR LA ZONE DE PLAN DE MASSE**
3D SCHALTUNG MIT EINER MESA-ISOLATION FÜR DEN GRUNDPLATTENBEREICH
3D CIRCUIT WITH A MESA ISOLATION FOR THE GROUND PLANE REGION

(30) Priorité: 19.12.2018 FR 1873965
(43) Date de publication de la demande: 24.06.2020
(73) Titulaire: Commissariat à l'énergie atomique et aux énergies alternatives, 75015 Paris (FR)
(72) Inventeur: BATUDE, Perrine, 38054 GRENOBLE CEDEX 09 (FR); ANDRIEU, François, 38054 GRENOBLE CEDEX 09 (FR)
(74) Mandataire: Brevalex

(56) Documents cités:
- US-A1- 2011 298 021
- US-A1- 2013 193 550
- US-B1- 9 023 688

## Description

### DOMAINE TECHNIQUE ET ART ANTÉRIEUR

La présente demande concerne le domaine des circuits intégrés dotés de composants électroniques répartis sur plusieurs niveaux, en particulier des transistors superposés. De tels dispositifs sont généralement qualifiés de circuits « 3D ».

Pour augmenter la densité de transistors dans les circuits intégrés, une solution consiste à répartir les transistors sur plusieurs niveaux superposés de couches semi-conductrices. De tels circuits intégrés en 3 dimensions ou « 3D » comportent ainsi typiquement au moins deux couches semi-conductrices disposées l'une au-dessus de l'autre et séparées entre elles par au moins une couche isolante.

Dans ce type de dispositif, il est connu d'intégrer une couche en matériau conducteur ou semi-conducteur dopé dite « de plan de masse » (« ground plane » selon la terminologie anglo-saxonne) ou « de grille arrière », disposée entre les deux couches semi-conductrices superposées. Une telle couche située sous une couche semi-conductrice de niveau supérieur est généralement séparée de cette couche semi-conductrice par l'intermédiaire d'une couche isolante. Cette couche isolante est prévue, en termes de matériau et d'épaisseur, de sorte à pouvoir mettre en oeuvre un couplage électrostatique entre la couche de plan de masse et la couche semi-conductrice de niveau supérieur. Ainsi, la couche de plan de masse peut permettre en particulier de contrôler la tension de seuil d'un transistor dont la région de canal s'étend dans la couche semi-conductrice de niveau supérieur et qui situé au-dessus de cette couche de plan de masse.

De même que la couche semi-conductrice supérieure peut être amenée à être gravée en une ou plusieurs zones actives, la couche de plan de masse peut être elle-même gravée en une ou régions distinctes lors du procédé de réalisation d'un tel circuit.

Pour réaliser une isolation autour d'une zone active ainsi qu'une isolation autour d'une portion de la couche de plan de masse un procédé de type communément appelé STI pour « shallow tench isolation » peut être alors réalisé.

Lors d'un procédé d'isolation STI on forme typiquement une tranchée dans une couche semi-conductrice et l'on dépose un ou plusieurs matériaux diélectriques tel que du dioxyde de silicium pour remplir la tranchée. On élimine ensuite le diélectrique en excès à l'aide d'au moins une étape de planarisation mécano-chimique (CMP). Un tel procédé est généralement couteux à mettre en oeuvre, en particulier du fait de la ou des étapes de planarisation.

Dans certains cas, la réalisation de zones isolantes de type STI peut nécessiter également une ou plusieurs étapes de densification d'oxyde à haute température. Or dans le cadre de la réalisation de certains circuit 3D où le transistor supérieur est formé directement au-dessus du dispositif inférieur, on cherche justement généralement à limiter le budget thermique de mise en oeuvre du ou des niveaux supérieurs de composants.

Le document US 9 761593 B2 émanant du demandeur, présente un procédé de réalisation d'un circuit 3D avec une couche de plan de masse dans lequel on réalise tout d'abord l'isolation autour de la zone active d'un transistor de niveau supérieur. L'isolation de la zone de plan de masse associée à cette zone active n'est réalisée qu'ultérieurement. La réalisation de l'isolation requiert un nombre d'étapes importants.

Un autre exemple de procédé de réalisation d'un circuit 3D est fourni par le document US 9023688 B1.

Il se pose donc le problème de trouver un nouveau procédé de réalisation d'un circuit 3D et en particulier comprenant la réalisation d'une isolation de la couche de plan de masse et qui soit amélioré vis-à-vis d'inconvénients mentionnés ci-dessus.

### EXPOSÉ DE L'INVENTION

Un mode de réalisation de la présente invention prévoit un procédé de réalisation d'un dispositif à niveaux de composants superposés comprenant dans cet ordre :
a) prévoir sur un niveau donné doté d'un ou plusieurs composants réalisés au moins partiellement dans une première couche semi-conductrice : un empilement comprenant une deuxième couche semi-conductrice apte à accueillir au moins un canal de transistor de niveau supérieur audit niveau donné, ledit empilement comprenant une couche dite de plan de masse en matériau conducteur ou semi-conducteur dopé ou apte à être dopé située entre la première couche semi-conductrice et la deuxième couche semi-conductrice ainsi qu'une couche isolante séparant la couche de plan de masse de la deuxième couche semi-conductrice, un ou plusieurs ilots étant définis dans la deuxième couche semi-conductrice,
b) former une grille d'un transistor sur au moins un ilot parmi lesdits un ou plusieurs ilots,
c) définir par gravure une ou plusieurs portions distinctes dans la couche de plan de masse de sorte à libérer un espace autour d'au moins une première portion gravée de la couche de plan de masse disposée sous et en regard dudit ilot,
d) former une zone isolante autour dudit ilot et de ladite première portion par dépôt d'au moins une couche en matériau isolant recouvrant la grille et ledit ilot, la couche isolante comblant ledit espace autour de la dite première portion de la couche de plan de masse,
e) formation de plots conducteurs traversant ladite couche en matériau isolant, un ou plusieurs desdits plots conducteurs étant connectés avec ledit ilot, au moins un autre plot conducteur étant connecté avec ladite première portion de la couche de plan de masse.

La mise en oeuvre d'une telle zone isolante est moins coûteuse qu'un procédé de type STI, nécessite un nombre d'étape importants.

Selon un mode de réalisation particulièrement avantageux pour lequel la couche de plan de masse est en matériau semi-conducteur, après définition desdites une ou plusieurs portions distinctes de la couche de plan de masse et préalablement au dépôt de la couche en matériau isolant : on forme une ou plusieurs zones de composé de métal et de semi-conducteur, par dépôt d'au moins une couche métallique respectivement sur ledit ilot et sur au moins une région de ladite première portion, puis au moins un recuit thermique. Ainsi, on effectue une siliciuration avant de réaliser l'isolation, ce qui peut notamment permettre de siliciurer sur une surface plus importante et de réaliser des contacts de qualité améliorée et en particulier de résistance réduite.

Selon une possibilité de mise en oeuvre, après définition desdites une ou plusieurs portions distinctes de la couche de plan de masse et préalablement à la formation desdites une ou plusieurs zones de composé de métal et de semi-conducteur, on forme une ouverture dans ladite couche isolante dévoilant une région de ladite première portion, au moins une zone de composé de métal et de semi-conducteur étant réalisée au niveau de ladite région de ladite première portion.

En variante, lorsque le procédé comprend des gravures aux étapes a), b) et c), la couche isolante peut être prévue avec une épaisseur de sorte qu'à la suite desdites gravures à l'issue de l'étape c), et préalablement à la formation de zones de composé de métal et de semi-conducteur, ladite première portion est dévoilée dans une zone qui s'étend autour dudit ilot et n'est pas située en regard dudit ilot. Une telle variante, peut permettre d'éviter une étape de photolithographie.

Avantageusement, parmi les plots conducteurs réalisés, on peut prévoir au moins un plot conducteur donné formé de sorte à traverser ledit espace comblé par ledit matériau isolant, ledit plot conducteur donné étant connecté au premier niveau N₁ de composants.

Selon un mode de réalisation particulier, la couche isolante séparant la couche de plan de masse de la deuxième couche semi-conductrice peut être formée d'un empilement de couches de matériaux diélectriques différents. Cela peut permettre de réaliser une couche isolante davantage résistante à la gravure.

Selon un autre mode de réalisation particulier dans lequel la couche isolante est en oxyde de silicium, préalablement à l'étape b) de formation de la grille on peut effectuer une implantation de carbone en surface de la couche isolante afin de former du SiOC ou une implantation de carbone et d'azote afin de former du SiOCN. En modifiant de cette manière la composition de la couche isolante, on rend cette dernière plus résistante à la gravure afin notamment de pouvoir préserver une épaisseur de cette couche lorsqu'on effectue un dopage pour réaliser des jonctions dans l'ilot semi-conducteur et permettre ainsi de protéger la couche de plan de masse lors de ce dopage.

Selon un mode de réalisation particulier dans lequel, préalablement à l'étape a), on effectue un assemblage par collage dudit empilement sur ledit niveau donné N₁, le procédé peut comprendre préalablement audit assemblage une étape de dopage de la couche de plan de masse, la couche de plan de masse étant de préférence dopée selon une concentration en dopants égale ou supérieure à 1^{e}20 at/cm³.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- les figures 1A-1G servent à illustrer un exemple de procédé tel que mis en oeuvre suivant un mode de réalisation de la présente invention et pour la mise en oeuvre d'une isolation d'une couche de plan de masse dans un circuit intégré 3D à niveaux de composants électroniques superposés ;
- la figure 2 sert à illustrer un mode de réalisation particulier d'un premier niveau de composants du circuit intégré 3D ;
- la figure 3 sert à illustrer un matériau de départ possible pour la réalisation d'un niveau supérieur de transistors disposé au-dessus du premier niveau ;
- la figure 4 sert à illustrer une variante de matériau de départ possible pour la réalisation du niveau supérieur de transistors ;
- les figures 5A-5E servent à illustrer une variante de réalisation pour laquelle on effectue une siliciuration d'une zone de la couche de plan de masse sans réaliser de photolithographie préalable pour découvrir cette zone ;
- la figure 6 sert à illustrer un exemple particulier d'agencement la couche isolante séparant la couche de plan de masse d'un ilot semi-conducteur destiné à accueillir une région de canal de transistor, et ce avant une étape de dopage de l'ilot°;
- la figure 7 sert à illustrer un exemple particulier de réalisation d'une couche isolante séparant la couche de plan de masse d'un ilot dans lequel une région de canal de transistor s'étend ;
- la figure 8 sert à illustrer un exemple particulier de procédé de modification par implantation de la composition de couche isolante séparant la couche de plan de masse de la couche semi-conductrice dans laquelle la région de canal de transistor d'un deuxième niveau est prévue ;

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

En outre, dans la description ci-après, des termes qui dépendent de l'orientation de la structure tels que « sur », « au-dessus », « sous », par-dessous « latéral », « supérieur », « inférieur » s'appliquent en considérant que la structure est orientée de la façon illustrée dans les figures.

### EXPOSÉ DÉTAILLÉ DE MODES DE RÉALISATION PARTICULIERS

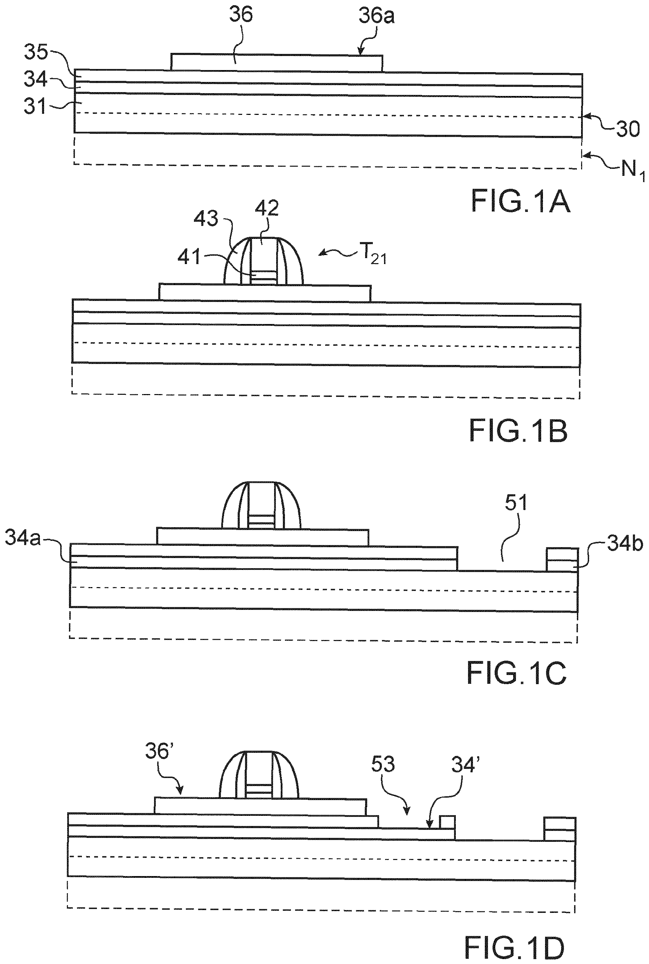

On se réfère à présent à la figure 1A donnant un exemple de structure de départ possible pour la mise en oeuvre d'un procédé suivant un mode de réalisation de la présente invention.

Cette structure comporte un premier niveau N₁ de composants électroniques représenté de manière schématique par un contour en trait discontinu.

Ce niveau N₁ est typiquement réalisé à partir d'un substrat comprenant une première couche semi-conductrice superficielle, par exemple en silicium, dans laquelle un ou plusieurs composants électroniques tels que des photo-sites et/ou des photodiodes et/ou des transistors sont au moins partiellement formés.

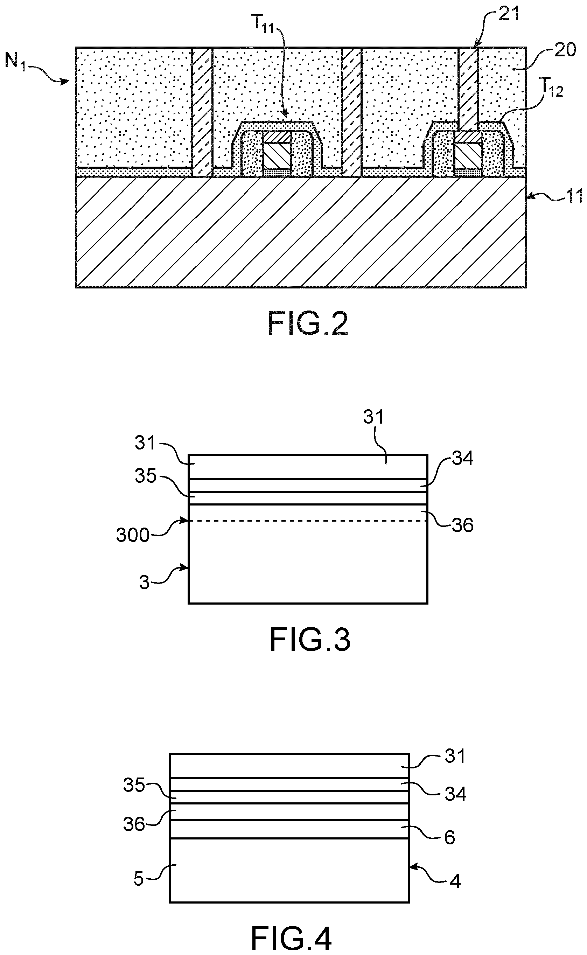

Dans l'exemple illustré sur la figure 2, les composants du premier niveau N₁ sont des transistors T₁₁ et T₁₂, en particulier de type MOS (MOS pour « Metal Oxide Semi-conductor ») et ont des régions de canal respectives qui s'étendent dans la première couche semi-conductrice 11. Une ou plusieurs zones conductrices 21 de connexion appartenant au premier niveau N₁ peuvent être également formées à ce stade au-dessus des transistors T₁₁, T₁₂ et sont connectées à ces derniers. Les zones conductrices 21 de connexion sont typiquement en métal, par exemple du tungstène, et sont agencées dans au moins une couche isolante 20 disposée sur les transistors.

Après avoir formé le premier niveau N₁ de composants, on réalise typiquement par report sur ce premier niveau N₁, un empilement de couches.

L'empilement est doté en particulier d'une couche 34 dite « de plan de masse » destinée à réaliser une polarisation par-dessous d'au moins un transistor d'un deuxième niveau N₂ et pouvoir en particulier moduler la tension de seuil de ce transistor. La couche 34 de plan de masse s'étend tout d'abord typiquement en pleine plaque autrement dit de manière continue entre le premier niveau N₁ et le deuxième niveau N₂. La couche 34 de plan de masse peut être un matériau conducteur tel qu'un métal ou un alliage de métal et de semi-conducteur ou être avantageusement un matériau semi-conducteur dopé ou destiné à être dopé. Par exemple, on prévoit la couche 34 à base de polysilicium dopé ou destiné à être dopé. Une couche 34 de plan de masse dopée lors de sa formation (dopage *in situ*) par exemple par dépôt de semi-conducteur sous forme amorphe ou polycristallin peut être réalisée. Un recuit peut permettre d'activer les dopants ou d'augmenter le niveau d'activation et de rendre le matériau semi-conducteur polycristallin dans le cas où il a été déposé sous forme amorphe. En variante ou en combinaison, on peut réaliser un dopage par implantation de cette couche 34 ce qui peut permettre d'atteindre un niveau de dopage élevé. Typiquement, on met en oeuvre une couche 34 de plan de masse de faible épaisseur, par exemple inférieure à 100 nm.

La couche 34 de plan de masse lorsqu'elle est à base d'un matériau semi-conducteur dopé est prévue de préférence avec une forte concentration en dopants avantageusement supérieure à celle prévue pour des zones de la deuxième couche semi-conductrice 36 destinées à former des régions de source et de drain ou d'accès au canal d'un transistor du deuxième niveau N₂. On cherche ainsi à éviter la formation de jonctions parasites sous la zone active. Avantageusement, la concentration en dopants est choisie de l'ordre de 1^{e}20 at/cm³ ou supérieure dans la couche de plan de masse 34.

Sur la couche 34 de plan de masse, une couche isolante 35 est disposée et sépare la couche 34 de plan de masse d'une deuxième couche semi-conductrice 36. La couche isolante 35 disposée entre la couche 34 de plan de masse et cette deuxième couche semi-conductrice 36, est configurée, en particulier en termes de matériau la composant et d'épaisseur, de sorte à permettre un couplage électrostatique entre la couche 34 de plan de masse et la deuxième couche semi-conductrice 36. La couche isolante 35 est par exemple en SiO₂ et a une épaisseur qui peut être comprise par exemple entre 5 nm et 100 nm. La couche isolante 35 peut être avantageusement une couche d'oxyde enterré (BOX pour « burried oxide ») d'un substrat semi-conducteur sur isolant dont la deuxième couche semi-conductrice 36 est la couche superficielle située sur le BOX.

L'empilement réalisé peut comprendre ou être formé sur une couche isolante 31 sur laquelle repose la couche de plan de masse 34. La couche isolante 31 est typiquement à base d'oxyde de silicium.

Selon un mode de réalisation particulier illustré sur la figure 1A, cette couche isolante 31 résulte de l'assemblage par collage de deux couches isolantes, par exemple en oxyde de silicium, une des deux couches isolantes recouvrant le premier niveau N₁ de composants. Une interface de collage 30 est ici représentée de manière schématique par le biais d'une ligne discontinue.

Ensuite, on définit un ou plusieurs ilots dans la deuxième couche semi-conductrice 36 aptes à former respectivement une ou plusieurs zones actives de transistors du deuxième niveau N₂. Pour cela, on peut effectuer une gravure sèche, par exemple à l'aide de HBr et CI par exemple, de la deuxième couche semi-conductrice 36.

Sur la vue de la figure 1A, un ilot 36a issu de la gravure de la deuxième couche semi-conductrice 36 est représenté. La gravure est dans cet exemple réalisée avec arrêt sur la couche isolante 35. La couche 34 de plan de masse n'est donc à ce stade pas gravée et est conservée continue.

On réalise ensuite des étapes de formation d'un transistor T₂₁, par exemple de type MOS. Cette formation comprend notamment une réalisation d'un diélectrique 41 de grille et d'une grille 42 sur l'ilot 36a, la formation d'espaceurs 43 de part et d'autre de flancs latéraux la grille 42 (figure 1B). Une ou plusieurs étapes de dopage pour réaliser des régions d'accès au canal et/ou de source situées dans l'ilot 36a de part et d'autre de la grille peuvent être également mises en oeuvre, typiquement par implantation.

Dans le cas où la couche de plan de masse 34 reste revêtue à cette étape de la couche isolante 35, cette couche isolante 35 permet de protéger des zones de la couche de plan de masse 34 de l'étape d'implantation des dopants dans l'ilot 36a. On évite ainsi la création de diode parasite en particulier dans le cas où la couche semi-conductrice 36 dans laquelle l'ilot 36a est formée est dopée selon un dopage de type opposé, par exemple un dopage de type N tandis que la couche de plan de masse est dopée selon un dopage de type P. On conserve dans ce cas une épaisseur h₂ de couche isolante 35 suffisante et qui peut être par exemple d'au moins 10 nm. L'épaisseur h₂ peut dépendre de plusieurs paramètres, dont le niveau de dopage de la couche de plan de masse, les conditions d'implantation des accès ainsi que le budget thermique pour réaliser le transistor.

Pour permettre de préserver à ce stade du procédé une couche isolante 35 d'épaisseur suffisante pour servir de protection, on peut prévoir de réaliser cette couche avec une composition particulière. Selon un mode de réalisation particulier, la couche isolante 35 peut être, dès sa formation, réalisée sous forme d'un empilement de plusieurs matériaux différents, par exemple un empilement oxyde de silicium/nitrure de silicium/oxyde de silicium, ou oxyde de silicium/oxyde d'hafnium/oxyde de silicium. De tels empilements peuvent permettre de rendre la couche isolante 35 plus résistante aux gravures effectuées et/ou au traitement humide nécessaire à la fabrication du transistor notamment pour définir l'ilot et/ou pour graver la grille, pour définir les espaceurs.

Selon un autre mode de réalisation particulier, on peut prévoir de modifier au cours du procédé la composition de la couche isolante 35, par exemple par implantation afin de la rendre plus résistante à la gravure. Par exemple, lorsque la couche isolante 35 est en oxyde de silicium, une implantation d'atomes de carbone et/ou d'azote peut être mise en oeuvre afin de former du SiOC ou du SiOCN davantage résistant que l'oxyde de silicium aux étapes de gravure humides, en particulier à base de HF. Une telle étape est alors réalisée typiquement après définition de l'ilot 36a et avant la définition de la grille.

Puis (figure 1C), on forme par gravure, un ou plusieurs motifs dans la couche 34 continue de plan de masse en plusieurs portions. On réalise ainsi un espace 51 par exemple sous forme d'une rainure autour d'une première portion 34a de la couche 34 de plan de masse. Dans le cas illustré sur la figure 1C où la couche 34 de plan de masse est divisée en plusieurs portions 34a, 34b cette rainure 51 forme une séparation entre la première portion 34a de la couche de plan de masse située sous et en regard du transistor T₂₁ et une deuxième portion 34b qui peut être prévue pour servir d'électrode arrière pour un autre transistor (non représenté). Une gravure localisée à travers l'ouverture d'un masquage (non représenté) est typiquement mise en oeuvre pour réaliser la découpe de la couche 34 de plan de masse. Cette découpe peut être réalisée par gravure à l'aide de HBr et Cl, en particulier lorsque la couche 34 de plan de masse est en polysilicium.

On peut ensuite réaliser des zones de prise de contact sur la deuxième couche semi-conductrice 36 et la couche 34 de plan de masse.

Pour cela, dans l'exemple de réalisation particulier illustré sur la figure 1D, on réalise au moins une ouverture 53 à travers la couche isolante 35 dévoilant une région 34' de la face supérieure de la portion 34a de la couche de plan de masse. Cette ouverture 53 est effectuée typiquement par photolithographie puis gravure à travers au moins un trou d'un masque de protection (non représenté). Une gravure sèche du diélectrique à l'aide CH2F2 et SF6 dans le cas d'un oxyde de silicium peut être par exemple utilisée pour former cette ouverture 53.

Après retrait de ce masque, on forme des zones 56a, 56b de composé de métal et de semi-conducteur sur des parties 36' dévoilées de l'ilot 36a, ainsi qu'une zone 56c, de composé de métal et de semi-conducteur sur la région 34' de la portion 34a de la couche de plan de masse. On dépose pour cela typiquement une couche de métal, sur la région 34' et les parties 36', et on effectue au moins un recuit thermique. Dans le cas, où l'ilot 36a est en silicium, on forme des zones siliciurées, en déposant par exemple du Nickel et/ou du NiPt avec par exemple une proportion de 5% à 15% de Pt et en effectuant au moins un recuit thermique.

Par exemple, lorsqu'on dépose une couche de Nickel, un recuit à une température comprise par exemple entre 250°C et 350°C selon une durée qui peut être par exemple de l'ordre de 30s peut être mis en oeuvre. Puis, on effectue un retrait sélectif du Nickel non réagi et on effectue un deuxième recuit pour former la phase NiSi. Dans ce cas, le deuxième recuit est typiquement, réalisé à une température supérieure à 350°C pendant un durée par exemple de l'ordre de 30 secondes.

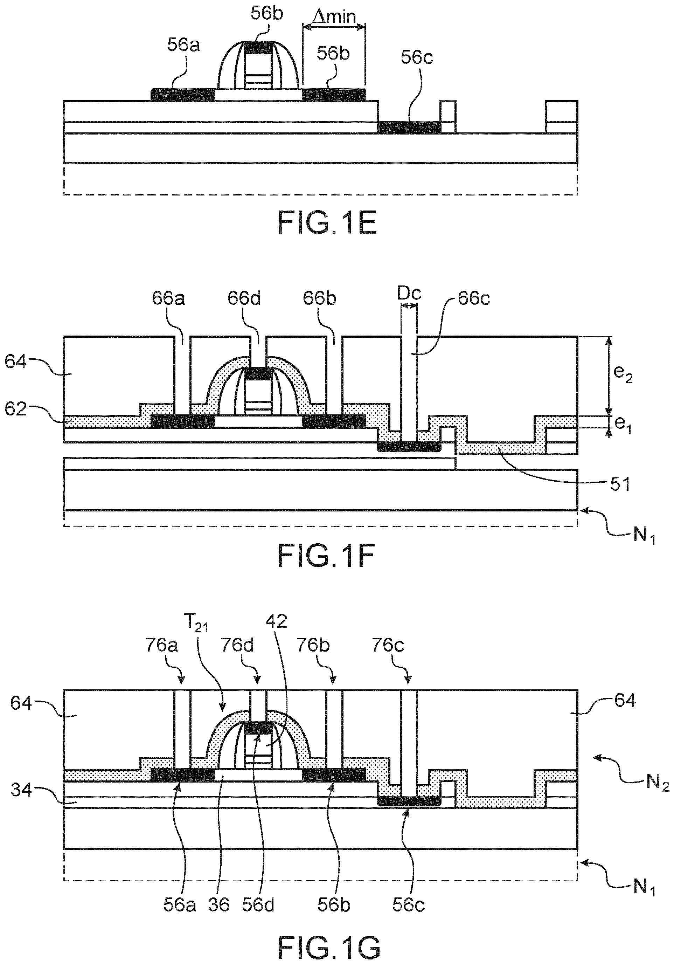

Dans l'exemple de réalisation illustré sur la figure 1E où au moins la partie supérieure de la grille 42 du transistor T₂₁ est en matériau semi-conducteur, par exemple en polysilicium, une zone 56d, de composé de métal et de semi-conducteur est concomitamment réalisée sur cette grille 42.

Une réalisation de la siliciuration à ce stade du procédé, et en particulier avant de mettre en oeuvre une isolation, permet de réaliser de manière avantageuse des zones 56a, 56b, 56c siliciurées de dimension minimale Δmin importante (dimension mesurée parallèlement au plan principal du substrat, i.e. passant par le substrat et parallèle au plan [O ;x ;y] du repère [O ;x ;y ;z]). Cette dimension Δmin pourra dépendre du noeud technologique mais pour un noeud technologique donné elle est typiquement supérieure à celle prévue pour un procédé conventionnel et dans lequel la siliciuration est mise en oeuvre au fond de trous réalisés à travers une couche isolante. En effet, on peut prévoir cette dimension Δmin supérieure à celle habituellement prévue pour former des trous destinés à accueillir des plots de contact.

La réalisation d'une siliciuration avant l'isolation de la couche de plan de masse et de l'ilot, permet par conséquent de mettre en oeuvre des contacts de résistance plus faible. On peut ainsi mettre en oeuvre un contact électrique amélioré avec l'ilot semi-conducteur 36a et/ou avec la couche de plan de masse 34.

Dans le cas où la couche de plan de masse est globalement dopée selon un dopage de type donné, par exemple de type P et comporte également des dopants réalisant un dopage de type opposé (ici de type N) et résultant d'un dopage de régions de l'ilot semi-conducteur 36a, les dimensions de la zone 56d siliciurée de la couche de plan de masse sont avantageusement prévues de sorte à occuper et dépasser une zone de jonction réalisée entre les deux types de dopage opposés.

On forme ensuite une isolation autour de la ou les zones actives ainsi que de la ou les portions de plan de masse. Cette isolation a donc ici la particularité d'être réalisée après formation de la ou les grilles de transistors respectivement sur le ou les ilots semi-conducteurs du deuxième niveau N₂.

Pour cela, on réalise ensuite une première couche isolante 62, par exemple une couche de type CESL (pour « Contact Etch Stop Layer ») en nitrure de silicium et d'épaisseur e₁ par exemple comprise entre 10 nm et 50 nm. La couche isolante 62 peut être prévue avec une épaisseur e₁ suffisante pour permettre de combler l'espace 51, par exemple sous forme d'une rainure pratiquée autour de la portion 34a de plan de masse.

La première couche isolante 62 peut être ensuite recouverte d'une couche isolante 64, par exemple une couche de type PMD (pour « pre-metal dielectric ») en oxyde de silicium et d'épaisseur e₂ typiquement supérieure à e₁ par exemple comprise entre 100 nm et 700 nm.

On forme ensuite (figure 1F) des trous 66a, 66b, 66c, 66d à travers la ou les couches isolantes 62, 64 et dévoilant respectivement les zones 56a, 56b, 56c, 56d, de composé de métal et de semi-conducteur. Les trous 66a, 66b, 66c, 66d ont une dimension critique De, par exemple comprise entre 20 nm et 500 nm, typiquement inférieure à la dimension minimale Δmin des zones 56a, 56b, 56c, 56d, de composé de métal et de semi-conducteur.

Les trous 66a, 66b, 66c, 66d sont ensuite remplis de matériau conducteur 64, en particulier un métal par exemple tel que du tungstène (figure 1G).

La réalisation des trous 66a, 66b, 66c, 66d typiquement par lithographie et gravure peut être réalisée concomitamment ou en variante séquentiellement. Il en va de même pour le remplissage qui peut être réalisé concomitamment ou séquentiellement.

On réalise ainsi des plots conducteurs 76a, 76b, en contact respectivement avec les zones siliciurées 56a, 56b réalisées sur la zone active du transistor T₂₁, autrement dit sur l'ilot 36a formé à partir de la deuxième couche semi-conductrice 36. On réalise également de cette manière un plot conducteur 76c, en contact la portion 34a de plan de masse située sous le transistor T₂₁. Un plot de contact 66d avec la grille peut également être formé lors de cette étape.

Un plot de contact (non représenté sur la figure 1G) pour établir une connexion avec le premier niveau N₁ peut être également formé concomitamment. Dans ce cas, il est réalisé par remplissage d'un trou traversant la couche isolante 31 disposée entre les deux niveaux N₁ et N₂. Ce trou est avantageusement pratiqué de manière à traverser la rainure 51 réalisée autour de la portion 34a de plan de masse.

Différentes manières de réaliser l'empilement dans lequel le deuxième niveau N₂ de composants est formé peuvent être prévues.

Dans l'exemple de réalisation illustré sur la figure 3, la deuxième couche semi-conductrice 36 dans laquelle on prévoit de former la ou les zones actives pour transistor(s) du deuxième niveau est une couche superficielle d'un substrat massif 3 (« bulk » selon la terminologie anglo-saxonne) et sur laquelle on réalise ensuite la couche isolante 35, puis on dépose la couche de plan de masse et une couche isolante 31 destinée à être collée avec le premier niveau N₁ de composants. Le collage est typiquement réalisé entre deux couches isolantes et en particulier d'oxyde de silicium. Dans ce cas, le premier niveau N₁ est revêtu d'une telle couche d'oxyde préalablement au collage. Après collage, la couche semi-conductrice 36 peut être détachée du reste du substrat massif par un procédé de type smartcut^{™} en créant une zone de fragilisation 300 par implantation d'ions hydrogène dans le substrat. Des étapes de polissage et de gravure chimique par exemple en utilisant du TMAH (Tetramethylammonium hydroxide) ou du TEAH (Tétraéthyl ammonium hydroxide) peuvent être également réalisées afin de retirer une épaisseur non-désirée du substrat massif.

Dans l'exemple de réalisation illustré sur la figure 4, la deuxième couche semi-conductrice 36 destinée à accueillir la région de canal du transistor T₂₁, est cette fois une couche superficielle d'un substrat 4 de type semi-conducteur sur isolant, par exemple un substrat de type SOI (silicium sur isolant) avec une couche de support semi-conductrice 5, une couche isolante 6 typiquement en oxyde de silicium entre la couche de support 4 et la couche semi-conductrice 36 superficielle. Sur ce substrat 4, on réalise ensuite la couche isolante 35, puis la couche 34 de plan de masse et la couche isolante 31 destinée à être collée avec le premier niveau N₁ de composants.

Après collage, la couche de support 5 et la couche isolante 6 du substrat 4 sont ensuite éliminées. La couche de support 5 peut être retirée par exemple à l'aide d'étapes de polissage et de gravure telles qu'évoquées précédemment pour le substrat massif. La couche isolante 6 peut être quant à elle retirée par gravure à l'aide de HF.

Avantageusement, lorsque la couche 34 de plan de masse est prévue en matériau semi-conducteur dopé, on réalise ce dopage par implantation avant l'assemblage par collage avec le premier niveau N₁. Ainsi, un tel dopage peut être effectué par exemple sur l'un ou l'autre des empilements illustrés sur les figures 3 et 4. On peut de cette manière réaliser une implantation de la couche de plan de masse 34 avec une concentration en dopants élevée et ce sans avoir nécessairement à traverser la couche semi-conductrice 36. Cela permet également de pouvoir effectuer un recuit d'activation de dopants à température élevée sans contrainte de budget thermique liée au niveau inférieur N₁ de composants. Effectuer un dopage de la couche 34 de plan de masse avant collage peut également permettre de conférer à la couche 34 de plan de masse un niveau de dopage élevé par implantation sans toutefois endommager la couche semi-conductrice 36 destinée accueillir une ou plusieurs régions de canal de transistors.

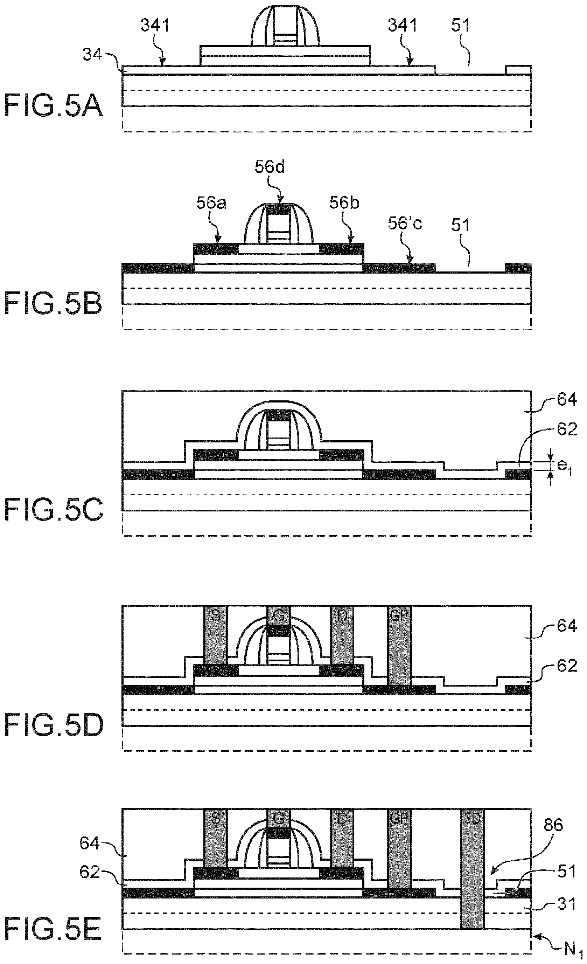

Une variante (figure 5A) de l'exemple de procédé de réalisation qui a été décrit précédemment prévoit qu'à l'issue de l'étape de découpe de la couche 34 de plan de masse, des parties 341 de la couche de plan de masse 34 qui ne sont pas recouvertes par un ilot 36a ou une zone active de la deuxième couche semi-conductrice 36 sont dévoilées. La couche isolante 35 est ainsi retirée aux endroits qui ne sont pas recouverts par la deuxième couche semi-conductrice 36. Une consommation de cette couche isolante 35 peut être réalisée notamment lors de la gravure de la ou les zones actives, en particulier lors de la définition de l'ilot 36a, en particulier lorsque cette gravure est réalisée à l'aide de HBr et CI par exemple.

Cette couche isolante 35 est typiquement retirée en plusieurs étapes et en plus d'un retrait partiel effectué lors de la gravure permettant de définir l'ilot 36a, on consomme des parties dévoilées de cette couche 35 lors d'une ou plusieurs étapes de réalisation du transistor T₂₁, par exemple lors de la gravure de la grille et éventuellement lors d'une ou plusieurs étapes de nettoyage, en particulier une étape de nettoyage réalisée à l'aide de HF après définition de la grille et avant implantation des régions de source et de drain. Une consommation de la couche isolante 35 peut également avoir lieu lors d'une éventuelle étape de désoxydation.

Ainsi, lorsque la rainure 51 est formée, la couche de plan de masse 34 n'est recouverte par la couche isolante 35 qu'aux endroits situés en regard de l'ilot 36a réalisé par gravure de la deuxième couche semi-conductrice 36.

On forme ensuite des zones 56a, 56b, de composé de métal et de semi-conducteur sur l'ilot 36a, ainsi qu'une zone 56'c, de composé de métal et de semi-conducteur sur les parties 341 dévoilées de la portion 34a ou les portions de la couche de plan de masse. Typiquement, ces zones 56a, 56b, 56c sont réalisées par un procédé comprenant un dépôt de métal et un ou plusieurs recuit(s) thermique(s). On réalise ainsi de manière avantageuse une siliciuration de la ou les portions de plan de masse, sans avoir à ouvrir la couche isolante 35 et en particulier sans avoir à réaliser d'étape supplémentaire de photolithographie. Dans l'exemple de réalisation illustré sur la figure 5B une zone 56d siliciurée est également formée sur la grille 42.

On réalise ensuite l'isolation autour de l'ilot 36a et de la portion 34a de plan de masse en déposant la première couche isolante 62 venant combler la rainure 51 puis la deuxième couche isolante 64 (figure 5C).

On forme alors (figure 5D) à travers les couches isolantes 62, 63 les trous pour les plots conducteurs 76a, 76b, 76c, 76d de contact et on remplit ces trous de matériau conducteur typiquement un métal tel que par exemple du tungstène.

Dans l'exemple de réalisation particulier illustré sur la figure 5E, un plot de conducteur 86 venant prendre contact sur le premier niveau N₁ est également formé. Un tel plot 86 est typiquement réalisé par formation d'un trou traversant les couches 62, 64 d'isolation, ce trou passant à travers la rainure 51 et traversant la couche isolante 31 et éventuellement d'autres couches sous-jacentes pour atteindre une zone de connexion du premier niveau N₁.

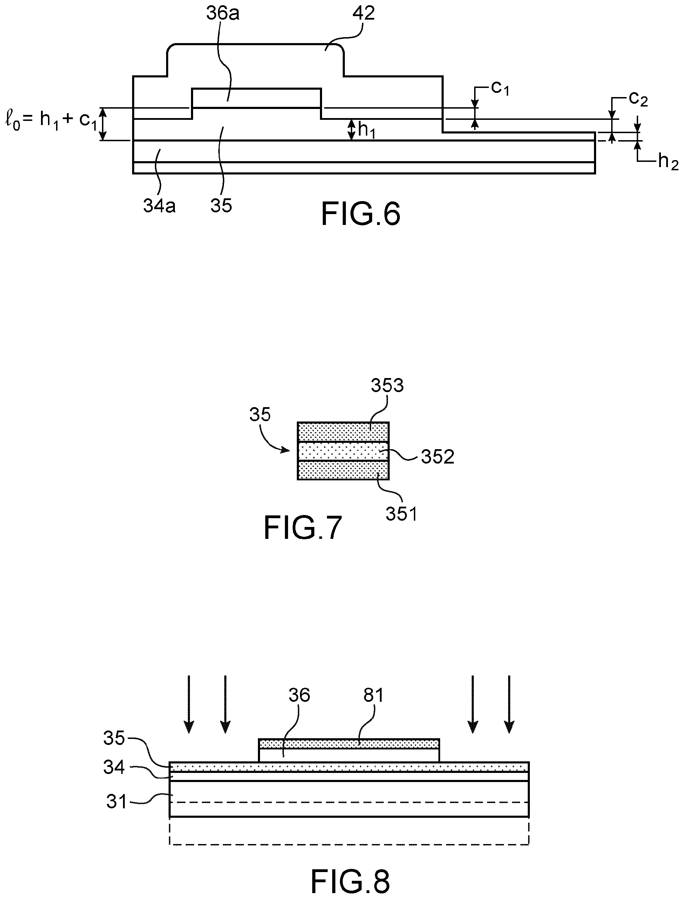

Un exemple de réalisation particulier est illustré sur la figure 6 dans un cas où la grille 42 de transistor formée sur l'ilot 36a déborde sur la couche isolante 35 et où une épaisseur c1 de la couche isolante 35 a été consommée, notamment lors de gravure permettant de définir l'ilot 36a et éventuellement d'étapes préalables au dépôt de la grille 42 et où une épaisseur c₂ de la couche isolante 35 a ensuite été consommée notamment lors de la gravure permettant de définir la grille 42 et éventuellement d'étapes de procédé réalisées après la gravure de la grille 42 mais préalablement à une étape de dopage par implantation de l'ilot 36a afin de réaliser des jonctions.

On prévoit dans ce cas, avantageusement, l'épaisseur totale e₀= h₁+c₁ de la couche isolante 35, ainsi que les étapes de gravure conduisant aux consommations d'épaisseurs c₁, c₂, de sorte à conserver, avant implantation pour réaliser les jonctions, une épaisseur h₂ d'une zone de la couche isolante 35 située en regard de la couche 34 de plan de masse et qui ne se trouve ni en regard de la grille 42 ni en regard de l'ilot 36a, suffisante pour empêcher ou tout au moins limiter un dopage de la couche 34 de plan de masse. On évite ainsi la création de diodes parasites. Lorsque la couche isolante 35 est en oxyde de silicium, on prévoit de conserver une épaisseur h₂ par exemple supérieure à 15 nm dans le cas d'une implantation réalisée au Bore avec une énergie entre 8 kev et 12 kev et une dose entre 1e15 at/cm³ et 6e15 at/cm³ et un recuit d'activation aux alentours de 1050°C et 14 nm de siliciuration avec un ground plane dopé de type N avec 2e20 at/cm³ .

Outre le fait de prévoir de conserver cette épaisseur h₂, une réalisation de jonction par implantation à énergie et/ou dose limitée(s) peut être mise en oeuvre. On entend par « dose limitée » et par « énergie limitée » par un exemple pour un transistor PMOS : une dose de bore inférieure à 2e15 at /cm³ et une énergie inférieure à 8 keV pour une couche de plan de masse dopée N à 2e20 at /cm³.

Pour permette de faciliter la conservation d'une épaisseur h₂ suffisante pour former un écran de protection de la couche de plan de masse 34 lors de la ou les étapes de dopage de l'ilot 36a, on peut comme indiqué précédemment et tel qu'illustré sur la figure 7, prévoir la couche isolante 35 sous forme d'un empilement de plusieurs matériaux 351, 352, 353, diélectriques différents. Par exemple un empilement comprenant une couche de nitrure de silicium disposée entre deux couches d'oxyde de silicium, ou bien une couche de HfO₂ disposée entre deux couches d'oxyde de silicium est réalisé. Le fait de prévoir une couche isolante 35 sous forme d'un tel empilement la rend plus résistante aux gravures, et en particulier aux gravures humides à l'aide de HF.

Il est également possible de rendre la couche isolante 35 davantage résistante aux différentes étapes de gravure en modifiant sa composition. Pour cela, on peut prévoir de modifier cette composition au moins en surface par implantation puis recuit. Par exemple, lorsque la couche isolante 35 est en oxyde de silicium, une implantation d'atomes de carbone et/ou d'azote peut être mise en oeuvre afin de former du SiOC ou du SiOCN davantage résistant aux étapes de gravure chimique, en particulier à l'aide de HF, que l'oxyde de silicium.

On peut réaliser un telle implantation visant à modifier la composition de la couche isolante 35 et la rendre plus résistante à la gravure après avoir effectué une gravure de l'ilot 36a. Ainsi dans l'exemple de réalisation particulier illustré sur la figure 8, après avoir effectué une gravure de l'ilot 36a en se servant d'un masque dur 81 comme masque de protection, on effectue une implantation de la couche isolante 35, en particulier à l'aide de carbone et/ou d'azote.

## Revendications

1. Procédé de réalisation d'un dispositif à niveaux (N1, N2) de composants superposés comprenant dans cet ordre :
a) prévoir sur un niveau donné (N₁) doté d'un ou plusieurs composants (T₁₁, T₁₂) réalisés au moins partiellement dans une première couche semi-conductrice (11) :
un empilement comprenant une deuxième couche semi-conductrice (36) apte à accueillir au moins un canal de transistor (T₂₁) de niveau (N₂) supérieur audit niveau donné (N₁), ledit empilement comprenant une couche (34) dite de plan de masse en matériau conducteur ou semi-conducteur dopé ou apte à être dopé située entre la première couche semi-conductrice (11) et la deuxième couche semi-conductrice (36) ainsi qu'une couche isolante (35) séparant la couche (34) de plan de masse de la deuxième couche semi-conductrice (36), un ou plusieurs ilots (36a) étant définis dans la deuxième couche semi-conductrice (36),
b) former une grille (42) d'un transistor (T₂₁) sur au moins un ilot (36a) parmi lesdits un ou plusieurs ilots,
c) définir par gravure une ou plusieurs portions (34a, 34b) distinctes dans la couche (34) de plan de masse de sorte à libérer un espace (51) autour d'au moins une première portion (34a) gravée de la couche de plan de masse disposée sous et en regard dudit ilot (36a),
d) former une zone isolante autour dudit ilot (36a) et de ladite première portion (34a) par dépôt d'au moins une couche en matériau isolant (62) recouvrant la grille (42) et ledit ilot (36a), la couche de matériau isolant (62) comblant ledit espace (51) autour de la dite première portion (34a) de la couche de plan de masse,
e) formation de plots conducteurs (66a, 66b, 66c, 86) traversant ladite couche en matériau isolant (62), un ou plusieurs desdits plots conducteurs (66a, 66b) étant connectés avec ledit ilot (36a), au moins autre plot conducteur (66c) étant connecté avec ladite première portion (34a) de la couche (34) de plan de masse.

2. Procédé selon la revendication 1, dans lequel la couche (34) de plan de masse est en matériau semi-conducteur et dans lequel après définition desdites une ou plusieurs portions distinctes de la couche de plan de masse et préalablement au dépôt de la couche en matériau isolant (62), on forme une ou plusieurs zones (56a, 56b, 56c) de composé de métal et de semi-conducteur, par :
- dépôt d'au moins une couche métallique respectivement sur ledit ilot (36a) et sur au moins une région de ladite première portion (34a),
- au moins un recuit thermique.

3. Procédé selon la revendication 2, dans lequel après définition desdites une ou plusieurs portions distinctes de la couche de plan de masse et préalablement à la formation desdites une ou plusieurs zones (56a, 56b, 56c) de composé de métal et de semi-conducteur, on forme une ouverture (53) dans ladite couche isolante (35) dévoilant une région de ladite première portion (34a), au moins une zone (56c) de composé de métal et de semi-conducteur étant réalisée au niveau de ladite région de ladite première portion (34a).

4. Procédé selon la revendication 2, dans lequel le procédé comprend des gravures aux étapes a), b) et c), et dans lequel la couche isolante (35) est prévue avec une épaisseur de sorte qu'à la suite desdites gravures à l'issue de l'étape c), et préalablement à la formation de zones (56a, 56b, 56c) de composé de métal et de semi-conducteur, ladite première portion (34a) est dévoilée dans une zone qui s'étend autour dudit ilot (36a) et n'est pas située en regard dudit ilot (36a).

5. Procédé selon l'une des revendications 2 à 4, dans lequel parmi lesdits plots conducteurs (66a, 66b, 66c, 86) au moins un plot conducteur donné (86) est réalisé de sorte à traverser ledit espace (51) comblé par ledit matériau isolant (62), ledit plot conducteur donné (86) étant connecté au premier niveau N₁ de composants.

6. Procédé selon l'une des revendications 1 à 5, dans lequel la couche isolante (35) séparant la couche (34) de plan de masse de la deuxième couche semi-conductrice (36) est formée d'un empilement de couches (351, 352, 353) de matériaux diélectriques différents.

7. Procédé selon l'une des revendications 1 à 6, dans lequel la couche isolante (35) est en oxyde de silicium et dans lequel préalablement à l'étape b) de formation de la grille on effectue une implantation de carbone en surface de la couche isolante (35) afin de former du SiOC ou une implantation de carbone et d'azote afin de former du SiOCN.

8. Procédé selon l'une des revendications 1 à 7, dans lequel préalablement à l'étape a) on effectue un assemblage par collage dudit empilement sur ledit niveau donné (N₁), le procédé comprenant préalablement audit assemblage une étape de dopage de la couche de plan de masse, la couche de plan de masse étant de préférence dopée selon une concentration en dopants égale ou supérieure à 1^{e}20 at/cm³.

## Patentansprüche

1. Verfahren zur Herstellung einer Vorrichtung mit Niveaus (N1, N2) aus überlagerten Komponenten, das in dieser Reihenfolge umfasst:
a) Vorsehen, auf einem gegebenen Niveau (N₁), das mit einer oder mehreren Komponenten (T₁₁, T₁₂) ausgerüstet ist, die mindestens teilweise in einer ersten Halbleiterschicht (11) ausgebildet sind:
eines Stapels, der eine zweite Halbleiterschicht (36) umfasst, die geeignet ist, mindestens einen Transistorkanal (T₂₁) mit einem Niveau (N₂) aufzunehmen, das höher als das gegebene Niveau (N₁) ist, wobei der Stapel eine Schicht (34), der Massenebene genannt, aus leitendem oder halbleitendem Material umfasst, das dotiert ist oder geeignet ist, dotiert zu werden, und zwischen der ersten Halbleiterschicht (11) und der zweiten Halbleiterschicht (36) angeordnet ist, sowie eine isolierende Schicht (35), die die Schicht der Massenebene (34) von der zweiten Halbleiterschicht (36) trennt, wobei eine oder mehrere Inseln (36a) in der zweiten Halbleiterschicht (36) definiert sind,
b) Bilden eines Gates (42) eines Transistors (T₂₁) auf mindestens einer Insel (36a) unter den einen oder mehreren Inseln,
c) Definieren, durch Ätzung, eines oder mehrerer separater Abschnitte (34a, 34b) in der Schicht der Massenebene (34), so dass ein Raum (51) freigemacht wird um mindestens einen ersten geätzten Abschnitt (34a) der Schicht der Massenebene, die unter und gegenüber der Insel (36a) positioniert ist,
d) Bilden einer isolierenden Zone um die Insel (36a) und den ersten Abschnitt (34a) durch Abscheiden von mindestens einer Schicht aus isolierendem Material (62), die das Gate (42) und die Insel (36a) bedeckt, wobei die Schicht aus isolierendem Material (62) den Raum (51) um den ersten Abschnitt (34a) der Schicht der Massenebene füllt,
e) Bilden von leitenden Pads (66a, 66b, 66c, 86), die durch die Schicht aus isolierendem Material (62) verlaufen, wobei einer oder mehrere der leitenden Pads (66a, 66b) mit der Insel (36a) verbunden sind, wobei mindestens ein anderes leitendes Pad (66c) mit dem ersten Abschnitt (34a) der Schicht der Massenebene (34) verbunden ist.

2. Verfahren nach Anspruch 1, wobei die Schicht der Massenebene (34) aus halbleitendem Material besteht und wobei, nach dem Definieren des einen oder der mehreren separaten Abschnitte der Schicht der Massenebene und vor dem Abscheiden derSchicht aus isolierendem Material (62), eine oder mehrere Zonen (56a, 56b, 56c) aus Metall- und Halbleiterverbindung gebildet werden, durch:
- Abscheiden von mindestens einer Metallschicht auf der Insel (36a) beziehungsweise auf mindestens einem Bereich des ersten Abschnitts (34a),
- mindestens ein thermisches Glühen.

3. Verfahren nach Anspruch 2, wobei nach der Definition eines oder mehrerer separater Abschnitte der Schicht der Massenebene und vor der Bildung der einen oder der mehreren Zonen (56a, 56b, 56c) der Metall- und der Halbleiterverbindung eine Öffnung (53) in der isolierenden Schicht (35) gebildet wird, die einen Bereich des ersten Abschnitts (34a) freilegt, wobei mindestens eine Zone (56c) der Metall- und Halbleiterverbindung auf dem Niveau des Bereichs des ersten Abschnitts (34a) ausgebildet wird.

4. Verfahren nach Anspruch 2, wobei das Verfahren Ätzungen in den Schritten a), b) und c) umfasst, und wobei die isolierende Schicht (35) mit einer Dicke vorgesehen ist, so dass nach den Ätzungen am Ende des Schritts c) und vor der Bildung der Zonen (56a, 56b, 56c) der Metall- und Halbleiterverbindung der erste Abschnitt (34a) in einer Zone freigelegt wird, die sich um die Insel (36a) erstreckt, und nicht gegenüber der Insel (36a) angeordnet ist.

5. Verfahren nach einem der Ansprüche 2 bis 4, wobei unter den leitenden Pads (66a, 66b, 66c, 86) mindestens ein gegebenes leitendes Pad (86) so ausgebildet ist, dass es durch den Raum (51) verläuft, der durch das isolierende Material (62) gefüllt ist, wobei das gegebene leitende Pad (86) mit dem ersten Niveau N₁ von Komponenten verbunden ist.

6. Verfahren nach einem der Ansprüche 1 bis 5, wobei die isolierende Schicht (35), die die Schicht der Massenebene (34) von der zweiten Halbleiterschicht (36) trennt, aus einem Stapel von Schichten (351, 352, 353) verschiedener dielektrischer Materialien gebildet wird.

7. Verfahren nach einem der Ansprüche 1 bis 6, wobei die isolierende Schicht (35) aus Siliziumoxid besteht, und wobei vor dem Schritt b) der Bildung des Gates eine Implantation aus Kohlenstoff an der Oberfläche der isolierenden Schicht (35) durchgeführt wird, um SiOC zu bilden oder eine Implantation von Kohlenstoff und Stickstoff, um SiOCN zu bilden.

8. Verfahren nach einem der Ansprüche 1 bis 7, wobei vor dem Schritt a) eine Montage durch Verkleben des Stapels auf dem gegebenen Niveau (N₁) durchgeführt wird, wobei das Verfahren vor der Montage einen Schritt der Dotierung der Schicht der Massenebene umfasst, wobei die Schicht der Massenebene vorzugsweise mit einer Dotierungskonzentration von 1^{e}20 at/cm³ oder mehr dotiert wird.

## Claims

1. Method for producing a device with superimposed levels (N1, N2) of components including,
in this order, the following steps:
a) providing on a given level (N₁) provided with one or more components (T₁₁, T₁₂) produced at least partially in a first semiconductor layer (11):
a stack including a second semiconductor layer (36) capable of receiving at least one transistor channel (T₂₁) of level (N₂) above said given level (N₁), said stack including a so-called ground plane layer (34) made of conductor or semiconductor material or doped semiconductor material situated between the first semiconductor layer (11) and the second semiconductor layer (36) as well as an insulator layer (35) separating the ground plane layer (34) from the second semiconductor layer (36), one or more islands (36a) being defined in the second semiconductor layer (36),
b) forming a gate (42) of a transistor (T₂₁) on at least one island (36a) among said one or more islands,
c) defining by etching one or more distinct portions (34a, 34b) in the ground plane layer (34) so as to free a space (51) around at least one first etched portion (34a) of the ground plane layer arranged under and facing said island,
d) forming an isolation zone around said island (36a) and said first portion (34a) by deposition of at least one layer made of insulator material (62) covering the gate (42) and said island (36a), the layer of insulator material (62) filling said space (51) around said first portion (34a) of the ground plane layer,
e) formation of conductive pads (66a, 66b, 66c, 86) traversing said layer made of insulator material (62), one or more of said conductive pads (66a, 66b) being connected with said island (36a), at least one other conductive pad (66c) being connected with said first portion (34a) of the ground plane layer (34).

2. Method according to claim 1, wherein the ground plane layer (34) is made of semiconductor material and in which after definition of said one or more distinct portions of the ground plane layer and prior to the deposition of the layer made of insulator material (62), one or more zones (56a, 56b, 56c) of compound of metal and semiconductor are formed, by:
- deposition of at least one metal layer respectively on said island (36a) and on at least one region of said first portion (34a),
- at least one thermal annealing.

3. Method according to claim 2, wherein after definition of said one or more distinct portions of the ground plane layer and prior to the formation of said one or more zones (56a, 56b, 56c) of compound of metal and semiconductor, an opening (53) is formed in said insulator layer (35) revealing a region of said first portion (34a), at least one zone (56c) of compound of metal and semiconductor being produced at the level of said region of said first portion (34a).

4. Method according to claim 2, wherein the method includes etchings at steps a), b) and c), and wherein the insulator layer (35) is provided with a thickness such that following said etchings at the end of step c), and prior to the formation of zones (56a, 56b, 56c) of compound of metal and semiconductor, said first portion (34a) is uncovered in a zone which extends around said island (36a) and is not situated facing said island (36a).

5. Method according to any of the claims 2 to 4, wherein among said conductive pads (66a, 66b, 66c) at least one given conductive pad (86) is produced so as to traverse said space (51) filled by said insulator material (62), said given conductive pad (86) being connected to the first level N₁ of components.

6. Method according to any of the claims 1 to 5, wherein the insulator layer (35) separating the ground plane layer (34) from the second semiconductor layer (36) is formed of a stack of layers of different dielectric materials (351, 352, 353).

7. Method according to any of the claims 1 to 6, wherein the insulator layer (35) is made of silicon oxide and in which prior to step b) of formation of the gate an implantation of carbon is carried out on the surface of the insulator layer (35) in order to form SiOC or an implantation of carbon and nitrogen in order to form SiOCN.

8. Method according to any of the claims 1 to 7, wherein prior to step a) an assembly by bonding of said stack on said given level (N₁) is carried out, the method including prior to said assembly a step of doping of the ground plane layer, the ground plane layer preferably being doped according to a concentration of dopants equal to or greater than 1^{e}20 at/cm³.
